# EUROPEAN PATENT SPECIFICATION

(11) **EP 3 232 474 B1**
(45) Date of publication and mention of the grant of the patent: **16.03.2022**
(21) Application number: 15778179.0
(22) Date of filing: 23.05.2015
(51) Int. Cl.: H01L 27/32, H01L 23/50, G06F 3/041, G06F 3/044

(54) **SUBSTRATE, TOUCH DISPLAY PANEL AND TOUCH DISPLAY DEVICE**
SUBSTRAT, BERÜHRUNGSEMPFINDLICHE ANZEIGETAFEL UND BERÜHRUNGSEMPFINDLICHE ANZEIGEVORRICHTUNG
SUBSTRAT, PANNEAU D'AFFICHAGE TACTILE ET AFFICHEUR TACTILE

(30) Priority: 09.12.2014 CN 201410749101
(43) Date of publication of application: 18.10.2017
(73) Proprietor: BOE Technology Group Co., Ltd., Beijing 100015 (CN)
(72) Inventor: SHI, Ling, Beijing 100176 (CN); WANG, Ming Hsi, Beijing 100176 (CN)
(74) Representative: Brötz, Helmut
(86) International application number: PCT/CN2015/079634
(87) International publication number: WO 2016/090854

(56) References cited:
- EP-A2- 2 750 007
- CN-A- 103 699 284
- CN-A- 103 926 724
- CN-A- 104 393 025
- CN-U- 204 204 861
- KR-A- 20130 011 673
- US-A1- 2009 135 158
- US-A1- 2009 278 813
- US-A1- 2012 249 454
- US-A1- 2013 147 730
- US-A1- 2014 333 572

## Description

### TECHNICAL FIELD

Embodiments of the present disclosure relate to a substrate, a touch display panel and a touch display device.

### BACKGROUND

Active Matrix Organic Light Emitting Diode (AMOLED) display becomes the mainstream of the display device owing to its characteristics such as fast response, high brightness, low power consumption, good view angle, suitable for flexible display, etc. The AMOLED display with touch function emerges in response to the demands on function diversification. Among the various touch technologies, On-cell touch technology and In-cell touch technology are widely used. The On-cell touch technology is usually used in medium and small-sized AMOLED displays. In contrast to the On-cell touch technology, the In-cell touch technology can make the display thinner, and thus its application in AMOLED display earns more attention.

In the case that the In-cell touch technology is applied to the AMOLED display, touch sensors are typically fabricated on the encapsulating substrate and thereafter the encapsulating substrate and the array substrate are bonded together, so that the touch sensors are provided between the array substrate and the encapsulating substrate. However, the above-mentioned structure is restricted to be applied in a glass-cover packaging process and can not be realized in a thin-film packaging process. In a thin-film packaging process, thin films are deposited on the array substrate in a vacuum environment to protect OLED of the array substrate from being corroded by water and oxygen and no glass covers provided on the array substrate are needed, i.e. no encapsulating substrates are provided, so that the touch sensors can not be fabricated on the encapsulating substrate. It can be seen that the In-cell touch technology is significantly restrained from being applied to AMOLED displays.

US 2012/249454 A1 provides a display device, which includes: a first substrate having a light extraction plane; a plurality of first electrodes; an organic electroluminescence layer; a plurality of second electrodes; a second substrate; a plurality of sensing electrodes allowing an object to be detected; and a plurality of driving electrodes forming a capacitance with the sensing electrodes and allowing the object to be detected. The first electrodes, the organic electroluminescence layer, the second electrodes, and the second substrate are provided in this order on the first substrate. The sensing electrodes and the driving electrodes are provided, in this order from a first substrate side, between the first substrate and the second substrate. Each of the sensing electrodes is constituted by a plurality of the first electrodes, and each of the driving electrodes is constituted by a plurality of the second electrodes.

US 2013/147730 A1 provides a touch-sensing display panel including an active device array substrate, a touch-sensing substrate and a display medium is provided. The touch-sensing substrate includes a first substrate, first touch-sensing electrodes, second touch-sensing electrodes, a dielectric layer and a black matrix. The first touch-sensing electrodes are parallel with each other and disposed on the first substrate. Each of the first touch-sensing electrodes has a plurality of first openings, respectively. Each of the second touch-sensing electrodes has a plurality of second openings, respectively. The second touch-sensing electrodes are intersected with the first touch-sensing electrodes. The black matrix is disposed between the first touch-sensing electrodes and the first substrate and is disposed between the second touch-sensing electrodes and the first substrate, wherein the black matrix has a plurality of pixel openings arranged in array. Each of the pixel openings is corresponding to one of the first openings or one of the second openings, respectively. In one embodiment, the touch-sensing substrate includes a plurality of first ground electrodes and a plurality of second ground electrodes. Each of the first ground electrodes is located between two neighbouring first touch-sensing electrodes, respectively. Each of the second ground electrodes is located between two neighbouring second touch-sensing electrodes, respectively. The first ground electrodes can reduce crosstalk occurred between the neighbouring first touch-sensing electrodes while the second ground electrodes can reduce crosstalk occurred between the neighbouring second touch-sensing electrodes.

### SUMMARY

The present invention provides a substrate as set out in independent claim 1. Preferred embodiments are defined in the dependent claims.

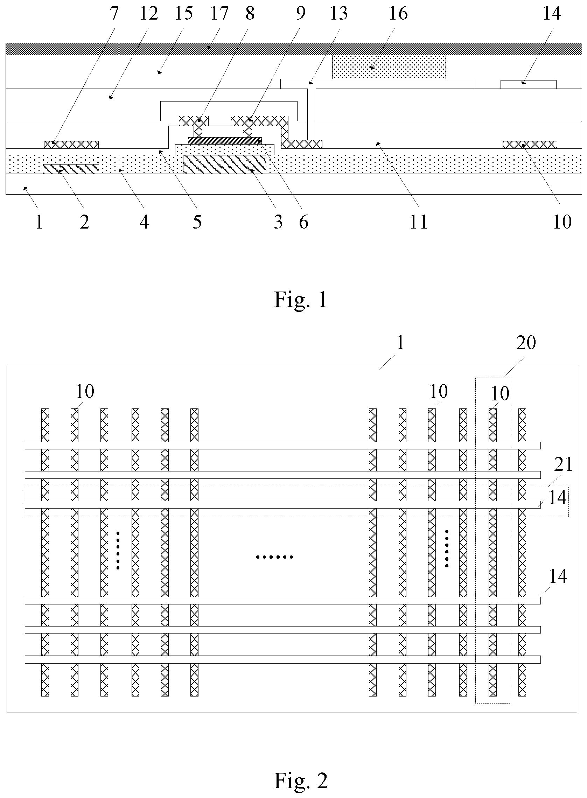

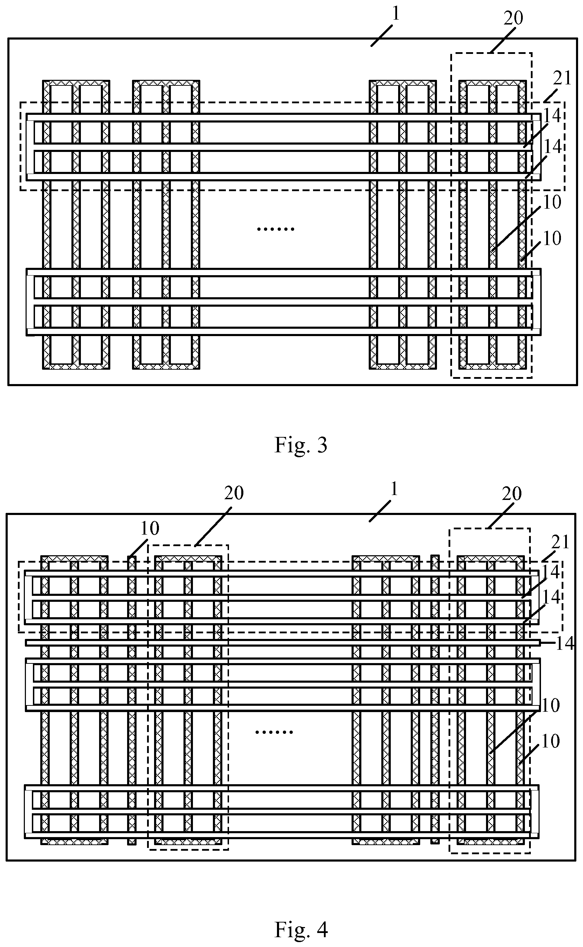

The claimed invention relates to the substrate described in relation to Fig. 4. Accordingly, any reference in the description to an embodiment or example in the context of Figs. 2 and 3 should be understood as a reference to an example of a substrate that is provided as useful for understanding the claimed invention but without being part of the claimed invention.

In the following brief description of the drawings and the subsequent detailed description the term "array substrate" is used synonym to the term "substrate". Moreover, it is noted that the used expression "embodiment(s) of the present disclosure" is meant to mean "embodiment(s) of the present invention".

### BRIEF DESCRIPTION OF THE DRAWINGS

In order to clearly illustrate the technical solutions of embodiments of the present disclosure, the drawings for the embodiments will be briefly described in the following; it is obvious that the drawings to be described hereafter are only related to some embodiments of the present disclosure and thus are not limitative of the present disclosure.
Fig. 1 is a schematic view illustrating an array substrate according to embodiments of the present disclosure;
Fig. 2 is a top view of the array substrate having the first arrangement of touch driving lines and touch sensing lines according to the embodiments of the present disclosure;
Fig. 3 is a top view of the array substrate having the second arrangement of the touch driving lines and the touch sensing lines according to the embodiments of the present disclosure;
Fig. 4 is a top view of the array substrate having the third arrangement of the touch driving lines and the touch sensing lines according to the embodiments of the present disclosure; and
Fig. 5 is a schematic view illustrating another array substrate according to the embodiments of the present disclosure.

### DETAILED DESCRIPTION

In order to make objects, technical details and advantages of embodiments of the present disclosure apparent, the technical solutions of the embodiments will be described in a clearly and fully understandable way in connection with the drawings related to the embodiments of the present disclosure.

At least one embodiment of the present disclosure provides an array substrate, so that the In-cell touch technology is implemented in an AMOLED display and the implementation of the In-cell touch technology is not limited by the fabrication process of the display panel of the AMOLED display. The array substrate includes a base substrate, and the base substrate has a plurality of pixel units formed by intersecting data lines and gate lines. The data lines and the gate lines are provided on the base substrate. Each pixel unit includes a bottom emission type OLED device and at least one thin film transistor (TFT), and the OLED device includes a transparent anode. The array substrate further includes a plurality of first electrodes disposed parallel with and in a same layer as the data lines, and a plurality of second electrodes disposed parallel with the gate lines and in a same layer as the anode. At least one first electrode constitutes a touch driving line, while at least one second electrode constitutes a touch sensing line.

It is to be noted that, each pixel unit of the array substrate may include one TFT or a plurality of TFTs, for example, a 2T1C control structure (in which 2 TFTs and 1 capacitor are provided) or a 6T2C control structure (in which 6 TFTs and 2 capacitors are provided) may be employed. Meanwhile, the TFT may be of bottom gate type or top gate type. The above-mentioned control structure or TFT exerts no influence on the configuration of the touch driving lines and the touch sensing lines, i.e. the embodiments of the disclosure are applicable to the array substrate in which each pixel unit includes one or more TFTs and the TFT is of top gate type or bottom gate type as described above, which will not be further described in detail here.

According to the present invention, the base substrate has the plurality of first electrodes formed in the same layer as the data lines and the plurality of second electrodes formed in the same layer as the anode, at least one first electrode constitutes the touch driving line and at least one second electrode constitutes the touch sensing line, so that the base substrate 1 has the touch sensors provided thereon and thus the In-cell touch technology is applicable to AMOLED displays fabricated with various processes.

### Embodiment 1

With reference to Fig. 1, for example, a relatively specific array substrate is illustrated. The array substrate includes a base substrate 1, a gate metal layer, a gate insulating layer 4, an active layer 5, an etching stop layer 6, a source/drain metal layer, a passivation layer 11, a flattening layer 12, an anode layer, a pixel defining layer 15, an organic light emitting layer 16 and a cathode 17 are formed in this order on the base substrate 1, the gate metal layer includes gate lines 2 and gate electrodes 3, the source/drain metal layer includes data lines 7, source electrodes 8 and drain electrodes 9, and the anode layer includes anodes 13. The gate electrodes 3, the gate insulating layer 4, the active layer 5, the etching stop layer 6, the source electrodes 8 and the drain electrodes 9 constitute bottom gate type TFTs, while the pixel defining layer 15, the organic light emitting layer 16, the anodes 13 and the cathode 17 constitute OLED devices. In the present embodiment, the case in which only one TFT is employed and such TFT is of bottom gate type is described as an example. However, in practical applications, a plurality of TFTs may be employed, and their structures may be the same as or different from that shown in Fig. 1, which will not be further described here.

In order to realize touch function, a plurality of first electrodes 10 are disposed in the source/drain metal layer and a plurality of second electrodes 14 are disposed in the anode layer. At least one first electrode 10 constitutes a touch driving line for transmitting touch driving signals and at least one second electrode constitutes a touch sensing line for transmitting touch sensing signals, so that the base substrate 1 has touch sensors provided thereon and thus the In-cell technology is applicable to AMOLED displays fabricated with various processes.

The first electrodes 10 are arranged uniformly in a row direction, and the second electrodes 14 are arranged uniformly in a column direction. The first electrodes 10 and the second electrodes 14 are both disposed in the non-emission area of the array substrate. In the embodiment of the present disclosure, the first electrodes 10 are arranged uniformly in the row direction and the second electrodes 14 are arranged uniformly in the column direction, so that touch detection points are distributed uniformly and the accuracy of touch detection can be improved. At least one column of pixel units are provided between two adjacent first electrodes 10, and at least one row of pixel units are provided between two adjacent second electrodes 14.

In an example not covered by the scope of the claims, the distance between the adjacent first electrodes 10 and the distance between the adjacent second electrodes 14 are set flexibly to achieve touch detection with different precisions.

Fig. 2 shows a top view of the array substrate, in which only the base substrate 1, the first electrodes 10 and the second electrodes 14 are illustrated for simplicity. The first electrodes 10 are uniformly arranged in the row direction and the second electrodes 14 are uniformly arranged in the column direction, and the first electrodes 10 and the second electrodes 14 are both disposed in the non-emission area of the array substrate. For example, one first electrode 10 constitutes one touch driving line 20 and one second electrode 14 constitutes one touch sensing line 21.

Fig. 3 shows a top view of the array substrate, in which only the base substrate 1, the first electrodes 10 and the second electrodes 14 are illustrated for simplicity. The first electrodes 10 are uniformly arranged in the row direction and the second electrodes 14 are uniformly arranged in the column direction, and the first electrodes 10 and the second electrodes 14 are both disposed in the non-emission area of the array substrate. For example, three first electrodes 10 are connected with one another at their two ends to constitute one touch driving line 20, and three second electrodes 14 are connected with one another at their two ends to constitute one touch sensing line 21. Of course, one touch driving line 20 may be constituted by two first electrodes 10 connected with each other at their two ends, and one touch sensing line 21 may be constituted by two second electrodes 14 connected with each other at their two ends; or one touch driving line 20 may be constituted by more than three first electrodes 10 connected with one another at their two ends, and one touch sensing line 21 may be constituted by more than three second electrodes 14 connected with one another at their two ends. The number of the first electrodes 10 for constituting one touch driving line 20 may be the same as or different from the number of the second electrodes 14 for constituting one touch sensing line 21, which will not be further described here. In at least one embodiment of the present disclosure, one touch driving line 20 includes a plurality of first electrodes 10 and one touch sensing line 21 includes a plurality of second electrodes 14, so that the resistance of the touch driving lines 20 and the touch sensing lines 21 can be reduced and the signal transmission efficiency can be improved.

In at least one embodiment of the present disclosure, for example, one column of pixel units (not shown) are provided between two adjacent touch driving lines 20, while one row of pixel units (not shown) are provided between two adjacent touch sensing lines 21. In at least one embodiment of the present disclosure, for example, the distance between adjacent touch driving lines 20 are set flexibly (that is, two or more columns of pixel units may be provided between two adjacent touch driving lines 20), and the distance between adjacent touch sensing lines 21 are set flexibly (that is, two or more rows of pixel units may be provided between two adjacent touch sensing lines 21), so as to achieve touch detection with different precisions.

Generally, there may be crosstalk between the touch driving lines 20 and between the touch sensing lines 21. In order to reduce such crosstalk, at least two columns of pixel units are provided between two adjacent touch driving lines 20, and at least one first electrode 10 insulated from the touch driving lines 20 is disposed between two adjacent touch driving lines 20; similarly, at least two rows of pixel units are provided between two adjacent touch sensing lines 21, and at least one second electrode 14 insulated from the touch sensing lines 21 is disposed between two adjacent touch sensing lines 21. Fig. 4 shows a top view of the array substrate, in which only the base substrate 1, the first electrodes 10 and the second electrodes 14 are illustrated for simplicity. The first electrodes 10 are uniformly arranged in the row direction and the second electrodes 14 are uniformly arranged in the column direction, and the first electrodes 10 and the second electrodes 14 are both disposed in the non-emission area of the array substrate. One touch driving line 20 is constituted by three first electrodes 10 connected with one another at their two ends and one first electrode 10 insulated from the touch driving lines 20 is disposed between two adjacent touch driving lines 20; one touch sensing line 21 is constituted by three second electrodes 14 connected with one another at their two ends and one second electrode 14 insulated from the touch sensing lines 21 is disposed between two adjacent touch sensing lines 21.

In the embodiment of the present disclosure, at least one first electrode 10 insulated from the touch driving lines 20 is disposed between adjacent touch driving lines 20 to prevent crosstalk between the touch driving lines 20, and at least one second electrode 14 insulated from the touch sensing lines 21 is disposed between adjacent touch sensing lines 21 to prevent crosstalk between the touch sensing lines 21.

In at least one embodiment of the present disclosure, for example, 20-30 adjacent first electrodes 10 constitute one touch driving line 20 while 5-15 adjacent second electrodes 14 constitute one touch sensing line 21, the illustration of such structure can be obtained with reference to Fig. 2 and Fig. 4, because such structure is similar to those in Fig. 2 and Fig. 4 except that the number of the first electrodes 10 constituting one touch driving line 20 is changed and the number of the second electrodes 14 constituting one touch sensing line 21 is changed. In the embodiment of the present disclosure, the resistance of the touch driving lines 20 and the resistance of the touch sensing lines 21 can be reduced while the touch detection precision can be guaranteed.

The beneficial effects of the embodiment of the present disclosure are as follows. The plurality of first electrodes 10 are formed in the same layer as the data lines 7 and the plurality of second electrodes 14 are formed in the same layer as the anodes 13, at least one first electrode 10 constitutes the touch driving line 20, and at least one second electrode constitutes the touch sensing line 21, so that the base substrate 1 has touch sensors provided thereon, and thus the In-cell technology is applicable to AMOLED displays fabricated with various processes. Furthermore, tow or more first electrodes 10 constitute one touch driving lines 20, and two or more second electrodes 14 constitute one touch sensing lines 21, so that the resistance of the touch driving lines 20 and the resistance of the touch sensing lines 21 are reduced. In addition, in accordance with the present invention, at least one first electrode 10 insulated from the touch driving lines 20 is disposed between adjacent touch driving lines 20 to reduce crosstalk between the touch driving lines 20, and at least one second electrode 14 insulated from the touch sensing lines 21 is disposed between adjacent touch sensing lines 21 to reduce crosstalk between the touch sensing lines 21.

### Embodiment 2

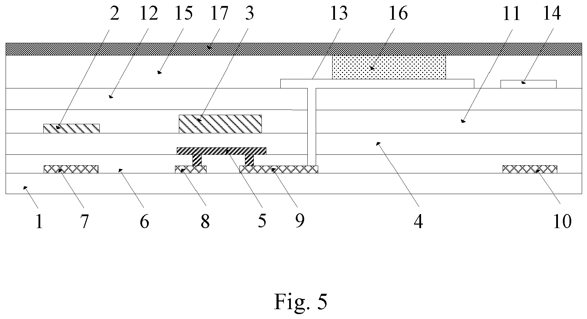

With reference to Fig. 5, another relatively specific array substrate is illustrated. The array substrate includes a base substrate 1, and a source/drain metal layer, an etching stop layer 6, an active layer 5, a gate insulating layer 4, a gate metal layer, a passivation layer 11, a flattening layer 12, an anode layer, a pixel defining layer 15, an organic light emitting layer 16 and a cathode 17 are formed in this order on the base substrate 1. The gate metal layer includes gate lines 2 and gate electrodes 3, the source/drain metal layer includes data lines 7, source electrodes 8 and drain electrodes 9, and the anode layer includes anodes 13. The gate electrodes 3, the gate insulating layer 4, the active layer 5, the etching stop layer 6, the source electrodes 8 and the drain electrodes 9 constitute top gate type TFTs, and the pixel defining layer 15, the organic light emitting layer 16, the anodes 13 and the cathode 17 constitute OLED devices. In the present embodiment, the case in which only one TFT is employed is described as an example. However, in practical applications, a plurality of TFTs may be employed, and their structures may be the same as or different from that shown in this figure, which will not be further described here.

In order to realize touch function, a plurality of first electrodes 10 are disposed in the source/drain metal layer and a plurality of second electrodes 14 are disposed in the anode layer. With reference to Fig. 2 and Fig. 4, at least one first electrode 10 constitutes the touch drive line 20 for transmitting touch driving signals and at least one second electrode 14 constitutes the touch sensing line 21 for transmitting touch sensing signals, so that the base substrate 1 has touch sensors provided thereon and thus the In-cell technology is applicable to AMOLED displays fabricated with various processes. The array substrate shown in Fig. 5 is only different from that shown in Fig. 1 in the structure of the TFTs. The touch driving lines 20 and the touch sensing lines 21 of the array substrate shown in Fig. 5 have the same arrangement as those shown in Fig. 2 to Fig. 4, and the descriptions thereof will be the same as those in embodiment 1 and will not be repeated here.

At least one embodiment of the present disclosure provides a touch display panel, and the touch display panel includes the array substrate according to the above embodiments. In the touch display panel, the touch driving lines and the touch sensing lines are both connected to the touch processing chip; or the touch driving lines are connected to the touch signal transmitter and the touch sensing lines are connected to the touch signal receiver, which will not be detailed here.

The beneficial effects of the embodiments of the present disclosure are as follows. The plurality of first electrodes are formed in the same layer as the data lines and the plurality of second electrodes are formed in the same layer as the anodes, at least one first electrode constitutes the touch driving line, and at least one second electrode constitutes the touch sensing line, so that the base substrate 1 has touch sensors provided thereon, and thus the In-cell technology is applicable to AMOLED displays fabricated with various processes. Furthermore, two or more first electrodes constitute one touch driving lines, and two or more second electrodes constitute one touch sensing lines, so that resistance of the touch driving lines and the resistance of the touch sensing lines are reduced. In addition, in accordance with the present invention, at least one first electrode insulated from the touch driving lines is disposed between adjacent touch driving lines to reduce crosstalk between the touch driving lines, and at least one second electrode insulated from the touch sensing lines is disposed between adjacent touch sensing lines to reduce crosstalk between the touch sensing lines.

At least one embodiment of the present disclosure provides a touch display device, and the touch display device includes the touch display panel according to the above embodiments.

The beneficial effects of the embodiments of the present disclosure are as follows. The plurality of first electrodes are formed in the same layer as the data lines and the plurality of second electrodes are formed in the same layer as the anodes, at least one first electrode constitutes the touch driving line, and at least one second electrode constitutes the touch sensing line, so that the base substrate 1 has touch sensors provided thereon, and thus the In-cell technology is applicable to AMOLED displays fabricated with various processes. Furthermore, two or more first electrodes constitute one touch driving lines, and two or more second electrodes constitute one touch sensing lines, so that resistance of the touch driving lines and the resistance of the touch sensing lines are reduced. In addition, in accordance with the present invention, at least one first electrode insulated from the touch driving lines is disposed between adjacent touch driving lines to reduce crosstalk between the touch driving lines, and at least one second electrode insulated from the touch sensing lines is disposed between adjacent touch sensing lines to reduce crosstalk between the touch sensing lines.

The foregoing embodiments merely are exemplary embodiments of the disclosure, and not intended to define the scope of the present invention as determined by the appended claims.

## Claims

1. A substrate, comprising:
a base substrate (1), wherein the base substrate (1) has:
a plurality of pixel units formed by intersecting data lines (7) and gate lines (2), wherein
the data lines (7) and the gate lines (2) are provided on the base substrate (1), each pixel unit comprises a bottom emission type organic light emitting diode, OLED, device and at least one thin film transistor, TFT, and the OLED device includes a transparent anode (13);
a plurality of first electrodes (10) disposed parallel with the data lines (7); and
a plurality of second electrodes (14) disposed parallel with the gate lines (2) and in a same layer as the anode (13),
wherein the plurality of first electrodes (10) are arranged at an equal interval in a row direction and the plurality of second electrodes (14) are arranged at an equal interval in a column direction,
**characterized in that**:
the plurality of first electrodes (10) are in a same layer as the data lines (7); a subset of the plurality of first electrodes (10) constitute a plurality of touch driving lines (20) and a subset of the plurality of second electrodes (14) constitute a plurality of touch sensing lines (21), wherein
each of the plurality of touch driving lines (20) is constituted by at least one respective first electrode (10) of the subset of the plurality of first electrodes (10), and each of the plurality of touch sensing lines (21) is constituted by at least one respective second electrode (14) of the subset of the plurality of second electrodes (14);
at least one first electrode (10) of the plurality of first electrodes (10) that is insulated from the touch driving lines (20) and is not part of the subset of the plurality of first electrodes (10) constituting the plurality of touch driving lines (20) is disposed between two adjacent touch driving lines (20) to reduce crosstalk between the touch driving lines (20);
and
at least one second electrode (14) of the plurality of second electrodes (14) that is insulated from the touch sensing lines (21) and is not part of the subset of the plurality of second electrodes (14) constituting the plurality of touch sensing lines (21) is disposed between two adjacent touch sensing lines (21) to reduce crosstalk between the touch sensing lines (21);
wherein the at least one first electrode (10) which is disposed between the two adjacent touch driving lines (20) is respectively spaced apart from each of the two adjacent touch driving lines (20) adjacent to the at least one first electrode (10) by at least one column of pixel units, and the at least one second electrode (14) which is disposed between the two adjacent touch sensing lines (21) is respectively spaced apart from each of the two adjacent touch sensing lines (21) adjacent to the at least one second electrode (14) by at least one row of pixel units.

2. The substrate according to claim 1, wherein
the OLED device further includes an organic light emitting layer (16); and
both of the plurality of first electrodes (10) and the plurality of second electrodes (14) are not overlapped with the organic light emitting layer (16) in a direction perpendicular to the base substrate (1).

3. The substrate according to claim 2, wherein
at least one column of pixel units are provided between two adjacent first electrodes (10), and at least one row of pixel units are provided between two adjacent second electrodes (14).

4. The substrate according to any one of claims 1-3, wherein
two or more first electrodes (10) of the subset of the plurality of first electrodes (10) constituting the plurality of touch driving lines (20) constitute one of the plurality of touch driving lines (20), and the two or more first electrodes (10) constituting one of the plurality of touch driving lines (20) are connected with each other at their two ends; and
two or more second electrodes (14) of the subset of the plurality of second electrodes (14) constituting the plurality of touch sensing lines (21) constitute one of the plurality of touch sensing lines (21), and the two or more second electrodes (14) constituting one of the plurality of touch sensing lines (21) are connected with each other at their two ends.

5. The substrate according to claim 4, wherein 20-30 adjacent first electrodes (10) of the subset of the plurality of first electrodes (10) constituting the plurality of touch driving lines (20) constitute one of the plurality of touch driving lines (20).

6. The substrate according to claim 4, wherein 5-15 adjacent second electrodes (14) of the subset of the plurality of second electrodes (14) constituting the plurality of touch sensing lines (21) constitute one of the plurality of touch sensing lines (21).

7. A touch display panel, comprising the substrate according to any one of claims 1 to 6.

8. A touch display device, comprising the touch display panel according to claim 7.

## Patentansprüche

1. Substrat, umfassend:
ein Basissubstrat (1), wobei das Basissubstrat (1) aufweist:
eine Mehrzahl von Pixeleinheiten, gebildet mittels sich überschneidender Datenleitungen (7) und Gate-Leitungen (2), wobei die Datenleitungen (7) und die Gate-Leitungen (2) auf dem Basissubstrat (1) vorgesehen sind, wobei jede Pixeleinheit eine Bodenemissionstyp-organische lichtemittierende Diode, OLED, -Vorrichtung und zumindest einen Dünnfilmtransistor, TFT, umfasst, und wobei die OLED-Vorrichtung eine transparente Anode (13) enthält;
wobei eine Mehrzahl von ersten Elektroden (10) parallel mit den Datenleitungen (7) angeordnet ist; und wobei eine Mehrzahl von zweiten Elektroden (14) parallel mit den Gate-Leitungen (2) und in einer gleichen Schicht wie die Anode (13) angeordnet ist,
wobei die Mehrzahl von ersten Elektroden (10) angeordnet sind in einem gleichen Intervall in einer Reihenrichtung und die Mehrzahl von zweiten Elektroden (14) angeordnet sind in einem gleichen Intervall in einer Spaltenrichtung,
**dadurch gekennzeichnet, dass**:
die Mehrzahl von ersten Elektroden (10) in einer gleichen Schicht sind wie die Datenleitungen (7);
eine Teilmenge der Mehrzahl von ersten Elektroden (10) eine Mehrzahl von Berührungstreiberleitungen (20) bildet und eine Teilmenge der Mehrzahl von zweiten Elektroden (14) eine Mehrzahl von Berührungsabtastleitungen (21) bildet, wobei
jede aus der Mehrzahl von Berührungstreiberleitungen (20) gebildet ist mittels zumindest einer jeweiligen ersten Elektrode (10) der Teilmenge der Mehrzahl von ersten Elektroden (10), und wobei jede aus der Mehrzahl von Berührungsabtastleitungen (21) gebildet ist mittels zumindest einer jeweiligen zweiten Elektrode (14) der Teilmenge der Mehrzahl von zweiten Elektroden (14);
wobei zumindest eine erste Elektrode (10) der Mehrzahl von ersten Elektroden (10), die isoliert von den Berührungstreiberleitungen (20) ist und die kein Teil der Teilmenge der Mehrzahl von ersten Elektroden (10), welche die Mehrzahl von Berührungstreiberleitungen (20) bilden, ist, zwischen zwei benachbarten Berührungstreiberleitungen (20) angeordnet ist, um Übersprechen zwischen den Berührungstreiberleitungen (20) zu verringern; und
wobei zumindest eine zweite Elektrode (14) aus der Mehrzahl von zweiten Elektroden (14), die von den Berührungsabtastleitungen (21) isoliert ist und die kein Teil der Teilmenge der Mehrzahl von zweiten Elektroden (14), welche die Mehrzahl von Berührungsabtastleitungen (21) bilden, ist, zwischen zwei benachbarten Berührungsabtastleitungen (21) angeordnet ist, um Übersprechen zwischen den Berührungsabtastleitungen (21) zu reduzieren;
wobei die zumindest eine erste Elektrode (10), die zwischen den zwei benachbarten Berührungstreiberleitungen (20) angeordnet ist, jeweils beabstandet ist von jeder der zwei benachbarten Berührungstreiberleitungen (20) benachbart zu der zumindest einen ersten Elektrode (10) mittels zumindest einer Spalte aus Pixeleinheiten, und wobei die zumindest eine zweite Elektrode (14), die zwischen den zwei benachbarten Berührungsabtastleitungen (21) angeordnet ist, jeweils beabstandet ist von jeder der zwei benachbarten Berührungsabtastleitungen (21) benachbart zu der zumindest einen zweiten Elektrode (14) mittels zumindest einer Reihe aus Pixeleinheiten.

2. Substrat gemäß Anspruch 1, wobei die OLED-Vorrichtung außerdem eine organische lichtemittierende Schicht (16) enthält; und wobei beide von der Mehrzahl von ersten Elektroden (10) und der Mehrzahl von zweiten Elektroden (14) nicht überlappt sind mit der organischen lichtemittierenden Schicht (16) in einer Richtung senkrecht zu dem Basissubtrat (1).

3. Substrat gemäß Anspruch 2, wobei zumindest eine Spalte aus Pixeleinheiten zwischen zwei benachbarten ersten Elektroden (10) vorgesehen ist, und wobei zumindest eine Reihe aus Pixeleinheiten zwischen zwei benachbarten zweiten Elektroden (14) vorgesehen ist.

4. Substrat gemäß einem der Ansprüche 1 bis 3, wobei zwei oder mehr erste Elektroden (10) der Teilmenge der Mehrzahl von ersten Elektroden (10), welche die Mehrzahl von Berührungstreiberleitungen (20) bildet, eine von der Mehrzahl von Berührungstreiberleitungen (20) bilden, und die zwei oder mehr ersten Elektroden (10), welche eine von der Mehrzahl von Berührungstreiberleitungen (20) bilden, miteinander an ihren zwei Enden verbunden sind; und
wobei zwei oder mehr zweite Elektroden (14) der Teilmenge der Mehrzahl von zweiten Elektroden (14), welche die Mehrzahl von Berührungsabtastleitungen (21) bildet, eine von der Mehrzahl von Berührungsabtastleitungen (21) bilden, und zwei oder mehr zweite Elektroden (14), welche eine von der Mehrzahl von Berührungsabtastleitungen (21) bilden, miteinander an ihren zwei Enden verbunden sind.

5. Substrat gemäß Anspruch 4, wobei 20-30 benachbarte erste Elektroden (10) der Teilmenge der Mehrzahl von ersten Elektroden (10), welche die Mehrzahl von Berührungstreiberleitungen (20) bildet, eine von der Mehrzahl der Berührungstreiberleitungen (20) bilden.

6. Substrat gemäß Anspruch 4, wobei 5-15 benachbarte zweite Elektroden (14) der Teilmenge der Mehrzahl von zweiten Elektroden (14), welche die Mehrzahl von Berührungsabtastleitungen (21) bildet, eine aus der Mehrzahl von Berührungsabtastleitungen (21) bilden.

7. Berührungsanzeigetafel, umfassend das Substrat gemäß einem der Ansprüche 1 bis 6.

8. Berührungsanzeigevorrichtung, umfassend die Berührungsanzeigetafel gemäß Anspruch 7.

## Revendications

1. Substrat, comprenant :
un substrat de base (1), dans lequel le substrat de base (1) présente :
une pluralité d'unités de pixels formées en coupant des lignes de données (7) et des lignes de grille (2), dans lequel
les lignes de données (7) et les lignes de grille (2) sont prévues sur le substrat de base (1), chaque unité de pixels comprend un dispositif à diode électroluminescente organique de type à émission par le bas, OLED, et au moins un transistor en couche mince, TFT, et le dispositif OLED inclut une anode transparente (13) ;
une pluralité de premières électrodes (10) disposées parallèles aux lignes de données (7) ; et
une pluralité de secondes électrodes (14) disposées parallèles aux lignes de grille (2) et dans une même couche que l'anode (13),
dans lequel la pluralité de premières électrodes (10) est agencée à un intervalle égal dans une direction de rangée et la pluralité de secondes électrodes (14) est agencée à un intervalle égal dans une direction de colonne,
**caractérisé en ce que** :
la pluralité de premières électrodes (10) sont dans une même couche que les lignes de données (7) ;
un sous-ensemble de la pluralité de premières électrodes (10) constitue une pluralité de lignes d'attaque tactiles (20) et un sous-ensemble de la pluralité de secondes électrodes (14) constitue une pluralité de lignes sensibles tactiles (21), dans lequel
chacune de la pluralité de lignes d'attaque tactiles (20) est constituée par au moins une première électrode (10) respective du sous-ensemble de la pluralité de premières électrodes (10), et chacune de la pluralité de lignes sensibles tactiles (21) est constituée par au moins une seconde électrode (14) respective du sous-ensemble de la pluralité de secondes électrodes (14) ;
au moins une première électrode (10) de la pluralité de premières électrodes (10) qui est isolée des lignes d'attaque tactiles (20) et ne fait pas partie du sous-ensemble de la pluralité de premières électrodes (10) constituant la pluralité de lignes d'attaque tactiles (20) est disposée entre deux lignes d'attaque tactiles (20) adjacentes pour réduire la diaphonie entre les lignes d'attaque tactiles (20) ; et
au moins une seconde électrode (14) de la pluralité de secondes électrodes (14) qui est isolée des lignes sensibles tactiles (21) et ne fait pas partie du sous-ensemble de la pluralité de secondes électrodes (14) constituant la pluralité de lignes sensibles tactiles (21) est disposée entre deux lignes sensibles tactiles (21) adjacentes pour réduire la diaphonie entre les lignes sensibles tactiles (21) ;
dans lequel l'au moins une première électrode (10) qui est disposée entre les deux lignes d'attaque tactiles (20) adjacentes est respectivement espacée de chacune des deux lignes d'attaque tactiles (20) adjacentes adjacentes à l'au moins une première électrode (10) par au moins une colonne d'unités de pixels, et l'au moins une seconde électrode (14) qui est disposée entre les deux lignes sensibles tactiles (21) adjacentes est espacée respectivement de chacune des deux lignes sensibles tactiles (21) adjacentes adjacentes à l'au moins une seconde électrode (14) par au moins une rangée d'unités de pixels.

2. Substrat selon la revendication 1, dans lequel
le dispositif OLED inclut en outre une couche électroluminescente organique (16) ;
et chacune de la pluralité de premières électrodes (10) et de la pluralité de secondes électrodes (14) ne sont pas en chevauchement avec la couche électroluminescente organique (16) dans une direction perpendiculaire au substrat de base (1).

3. Substrat selon la revendication 2, dans lequel
au moins une colonne d'unités de pixels sont prévues entre deux premières électrodes (10) adjacentes, et au moins une rangée d'unités de pixels sont prévues entre deux secondes électrodes (14) adjacentes.

4. Substrat selon l'une quelconque des revendications 1 - 3, dans lequel
deux ou plusieurs premières électrodes (10) du sous-ensemble de la pluralité de premières électrodes (10) constituant la pluralité de lignes d'attaque tactiles (20) constituent une de la pluralité de lignes d'attaque tactiles (20), et les deux ou plusieurs premières électrodes (10) constituant une de la pluralité de lignes d'attaque tactiles (20) sont connectées l'une à l'autre à leurs deux extrémités ; et
deux ou plusieurs secondes électrodes (14) du sous-ensemble de la pluralité de secondes électrodes (14) constituant la pluralité de lignes sensibles tactiles (21) constituent une de la pluralité de lignes sensibles tactiles (21), et les deux ou plusieurs secondes électrodes (14) constituant une de la pluralité de lignes sensibles tactiles (21) sont connectées l'une à l'autre à leurs deux extrémités.

5. Substrat selon la revendication 4, dans lequel 20-30 premières électrodes (10) adjacentes du sous-ensemble de la pluralité de premières électrodes (10) constituant la pluralité de lignes d'attaque tactiles (20) constituent une de la pluralité de lignes d'attaque tactiles (20).

6. Substrat selon la revendication 4, dans lequel 5-15 secondes électrodes (14) adjacentes du sous-ensemble de la pluralité de secondes électrodes (14) constituant la pluralité de lignes sensibles tactiles (21) constituent une de la pluralité de lignes sensibles tactiles (21).

7. Panneau d'affichage tactile, comprenant le substrat selon l'une quelconque des revendications 1 à 6.

8. Afficheur tactile, comprenant le panneau d'affichage tactile selon la revendication 7.
